Europäisches Patentamt

European Patent Office

Office européen des brevets

(11) Publication number: **0 258 735**
**A2**

## EUROPEAN PATENT APPLICATION

(21) Application number: **87111983.0**

(22) Date of filing: **18.08.87**

(51) Int. Cl.4: **H03F 1/30**

(30) Priority: **23.08.86 JP 128485/86 U**

(43) Date of publication of application:
**09.03.88 Bulletin 88/10**

(84) Designated Contracting States:
**DE FR GB IT**

(71) Applicant: **HORIBA, LTD.**
**2 Miyanohigashi-machi Kissyoin**
**Minami-ku Kyoto(JP)**

(72) Inventor: **Matsumoto, Naoyuki**
**21 Banchi Minamiharamachi Nishinokyo**
**Nakagyo-ku Kyoto(JP)**

(74) Representative: **Patentanwälte TER MEER -**
**MÜLLER - STEINMEISTER**
**Mauerkircherstrasse 45**
**D-8000 München 80(DE)**

(54) **Process circuit for use in voltage-output type sensors.**

(57) The process circuit for use with voltage-output type sensors is provided with an automatic connection polarity-switching over means (X) for alternately and automatically switching over the connection polarity of said voltage-output type sensor (S) to a preamplifier (A) from a noninverted condition to an inverted condition and vice versa. For cancelling not only an input voltage but also a bias current induced offset voltage of said sensor (S). The difference is taken between a detected voltage under said noninverted condition and a voltage under said inverted condition of said connection polarity. The measured value is then only dependent from the electromotive force of the sensor, for example a thermopile (S).

Fig . 3

EP 0 258 735 A2

## PROCESS CIRCUIT FOR USE IN VOLTAGE-OUTPUT TYPE SENSORS

The present invention relates to an improved process circuit to which voltage-output type sensors, such as thermocouples and thermocoiles, are connected.

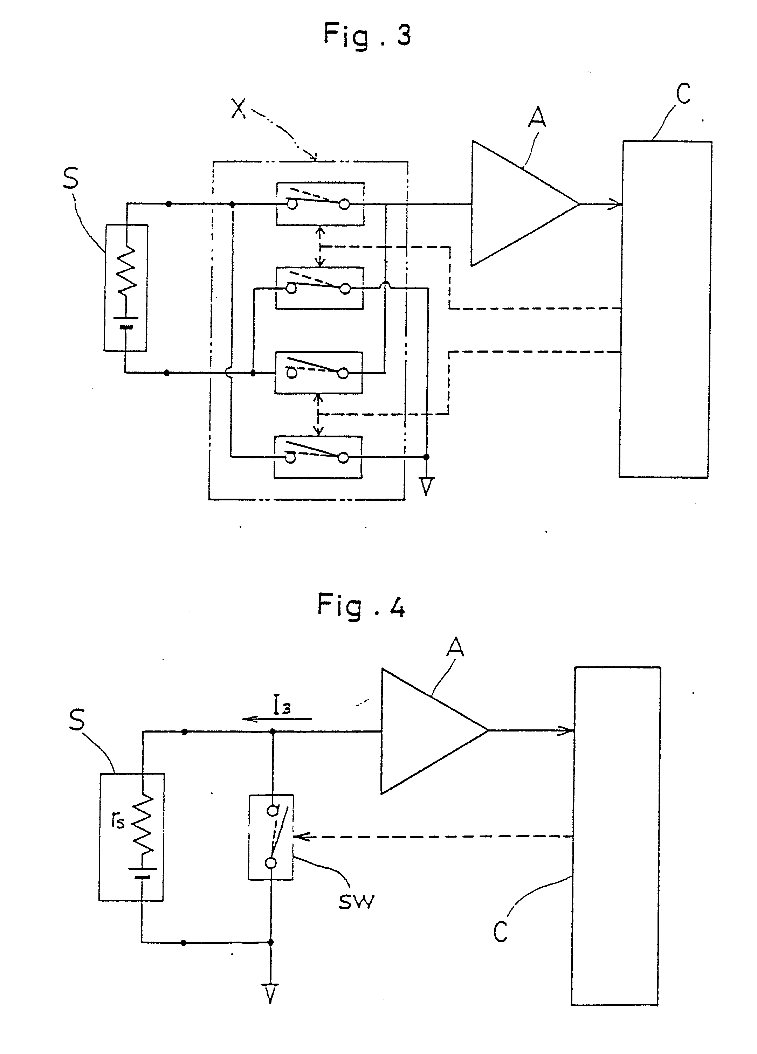

For example, as shown in Fig. 4, in a known radiation thermometer, in general, a thermocoile S is used together with a process circuit for cancelling an input offset voltage at a preamplifier A by connecting a switch SW in parallel to the thermopile S (voltage-output type sensor) which switch SW is automatically ON/OFF controlled by a measuring-operating-controlling circuit C connected to said preamplifier A, to take a difference between a detected value under an ON-condition and that under an OFF-condition of said switch SW.

However, the offset voltage at said preamplifier A includes two kinds of values that is to input offset voltage and an offset voltage generated by an input bias current $I_B$ and a resistance $r_s$ of said thermopile S. In the process circuit having the above described conventional construction, the former input offset voltage can be cancelled but the latter offset voltage generated by said input bias current $I_B$ and said resistance $r_s$ of the thermopile S cannot be cancelled, so that the problem remains that a highly accurate measurement cannot be attained.

In order to reduce the influence of such an offset voltage generated by the input bias current $I_B$ and the resistance $r_s$ of the thermopile S, the use of high-grade amplifiers, such as MOS-TOP type amplifiers, as said preamplifier A has been suggested. However, amplifiers of this type generally produce large noises inducing the disadvantage that it is very difficult to measure a minute voltage such as an output of the thermopile S. Moreover, the production costs for such a measuring instrument are remarkably increased.

In the light of the above described problem, it is an object of the present invention to provide a process circuit for use in a voltage-output type sensor capable of cancelling not only an input offset voltage in a preamplifier but also an offset voltage generated by an input bias current and a resistance of a voltage-output type sensor, such that a highly accurate measurement can be achieved in spite of a surprisingly very simple and economical constructional improvement.

In order to achieve the above described object, a process circuit for use in voltage-output type sensors is characterized in that an automatic connection polarity-switching over means is provided for alternately and automatically switching over the connection polarity of said voltage-out-put type sensor to a preamplifier from a noninversion condition to an inversion condition and vice versa between them, and in that by taking a difference between a detected voltage value under said noninversion condition and a voltage value under said inversion condition of the connection polarity not only an input offset voltage to said preamplifier but also an offset voltage generated by an input bias current and a resistance of said voltage-output type sensor are cancelled.

With a process circuit for voltage-output type sensors according to the present invention, as will become more obvious from the following description of the preferred embodiments, not only the input offset voltage in the preamplifier but also the offset voltage generated by the input bias current and the resistance of the voltage-output type sensor can be effectively cancelled. Thus, a highly accurate measurement can always be achieved if the difference is taken between the detected values under the noninversion condition and the inversion condition of the connection polarity of the voltage-output type sensor at the input of a preamplifier stage for the voltage-output sensor. The constructional concept of the invention is very simple and provides for an economical improvement of the measuring accuracy of voltage-output type sensors.

Preferred embodiments of a process circuit for use in voltage-output type sensors according to the present invention are shown in Figs. 1 to 3, in which

Fig. 1 is a block circuit diagram of a radiation thermometer in which a thermopile as only one example of the voltage-output type sensors is used;

Fig. 2(A), (B) is a schematic diagram showing the principal parts of a switch circuit for explaining the opera tion, respectively;

Fig. 3 is a block circuit diagram of one modification; and

Fig. 4 (already explained) is a block circuit diagram showing a radiation thermometer in which a thermopile of conventional construction is used.

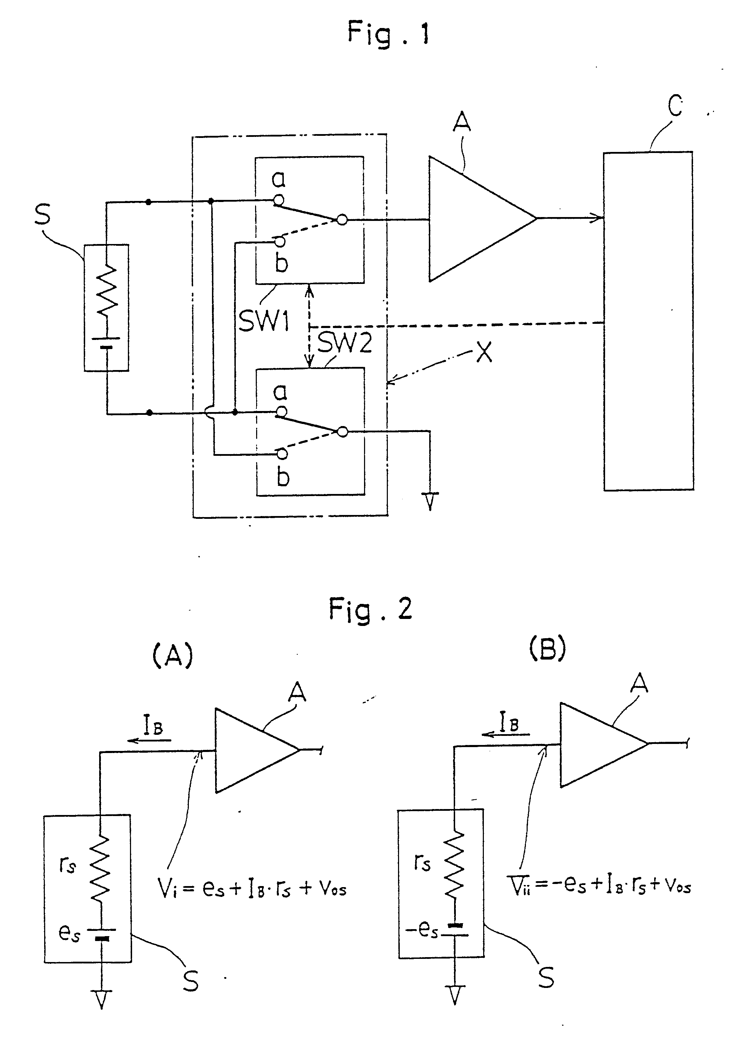

The preferred embodiments of the present invention will be below described with reference to Figs. 1 to 3.

Referring now to Fig. 1, a voltage-output type sensor (thermopile) S is connected to a process circuit for use in voltage-output type sensors according to the present invention.

Said process circuit for use in voltage-output type sensors comprises two highly responsive switching-over analog switches SW1, SW2 which are alternately and automatically switched-over to a noninversion side terminal (a) and an inversion side terminal (b), respectively, at appointed points of time by a measuring-operating-controlling circuit C (mainly comprising an AD convertor and a CPU) provided in a stage subsequent to a preamplifier A as an automatic connection polarity-switching over means X for alternately and automatically switching over the connection polarity of the thermopile S and the preamplifier A for the thermopile S to a noninversion condition and an inversion condition, respectively, provided between the thermopile S and the preamplifier A for the thermopile S.

In the case where both said switching-over analog switches SW1, SW2 are switched over to a side of the noninversion side terminal (a), the connection polarity of the thermopile S and the preamplifier A come to be in the noninversion condition, as schematically shown in Fig. 2(A). At this time, if the input bias current of the preamplifier A is $I_B$, an input offset voltage is $v_{os}$, an electromotive force of the thermopile S is $e_s$ , and a resistance (an output impedance) is $r_s$, the input voltage $V_i$ to the preamplifier A is expressed by the following equation (1):

$$V_i = e_s + I_B \bullet r_s + v_{os} \quad (1)$$

Accordingly, if the amplifier factor of the preamplifier A is $\alpha$, the output voltage $V_1$ of the preamplifier A which is the input voltage for the measuring-operating-controlling circuit C is defined by the following equation (2):

$$V_1 = \alpha (e_s + I_B \bullet r_s + v_{os}) \quad (2)$$

On the other hand, in the case where both said switching-over analog switches SW1, SW2 are switched over to the side of the inversion side terminal (b), the connection polarity of the thermopile S and the preamplifier A come to be in the inversion condition, as schematically shown in Fig. 2(B). At this time, an input voltage $V_{ii}$ to the preamplifier A is expressed by the following equation (3):

$$V_{ii} = - e_s + I_B \bullet r_s + v_{os} \quad (3)$$

Accordingly, the output voltage $V_{11}$ of the preamplifier A which is the input voltage for the measuring-operating-controlling circuit C, is defined by the following equation (4):

$$V_{11} = \alpha (-e_s + I_B \bullet r_s + v_{os}) \quad (4)$$

In said measuring-operating-controlling circuit C the difference between said equation (2) and said equation (4), that is to say

$$V_1 - V_{11} = \alpha (e_s + I_B \bullet r_s + v_{os})$$
$$-\alpha (-e_s + I_B \bullet r_s + v_{os})$$
$$= 2\alpha e_s$$

is calculated. As a result, both the input offset voltage $v_{os}$ to said preamplifier A and the offset voltage $I_B \bullet r_s$ generated by the input bias current $I_B$ and the resistance $r_s$ of the thermopile S can be cancelled. Accordingly, a highly accurate measured value of $2\alpha e_s$ which is responsive merely to the electromotive force $e_s$ of the thermopile S is obtained.

Fig. 3 shows a whole block circuit in which said automatic connection polarity-switching over means X comprises a standard C-MOS type analog switch (an assembly of the ON/ OFF analog switch elements).

Other possible constructions with basically the same operational function as in said Fig. 1, are readily available for the electronic expert so that their description is omitted.

As becomes obvious from the above description, with a process circuit for use in voltage output type sensors according to the present invention, not only an input offset voltage to a preamplifier but also an offset voltage generated by an input bias current and a resistance of a voltage-output type sensor can be satisfactorily cancelled, such that a highly accurate measurement can be always attained, by taking the difference between a detected value under a noninversion condition and that under an inversion condition. Thus, the concept of this invention is remarkably simple and provides for a highly effective even though economical improvement for various kinds of voltage-output type sensors by using an automatic connection polarity-switching over means for alternately and automatically switching over a connection polarity of the voltage-output type sensor and. the preamplifier for the voltage-output type sensor to the noninversion condition and the inversion condition, respectively.

## Claims

1. A process circuit for use with voltage-output type sensors, **characterized in that**
-an automatic connection polarity-switching over means (SW1, SW2; X) is provided for alternately and automatically switching over the connection polarity of said voltage-output type sensor (S) to a preamplifier (A) from a noninversion condition to an inversion condition and vice versa between them, and in that
-by taking a difference between a detected voltage value ($V_1$) under said noninversion condition and a voltage value ($V_{11}$) under said inversion condition of the connection polarity not only an input offset voltage ($v_{os}$) to said preamplifier (A) but also an offset voltage ($I_B \bullet r_s$) generated by an input bias current and a resistance of said voltage-output type sensor (S) are cancelled.

2. The process circuit for use in voltage-output type sensors as set forth in Claim 1, **characterized in that** said automatic connection polarity-switching over means comprises an anolog switch (SW).

3. The process circuit for use in voltage-output type sensors as set forth in Claim 1, **characterized in that** said automatic connection polarity-switching over means comprises a C-MOS type analog switch.

# Fig . 1

# Fig . 2

(A)

$$V_i = e_s + I_B \cdot r_s + V_{os}$$

(B)

$$V_{ii} = -e_s + I_B \cdot r_s + V_{os}$$

## Fig . 3

## Fig . 4